# EUROPEAN PATENT APPLICATION

(11) **EP 4 524 965 A1**
(43) Date of publication of application: **19.03.2025**
(21) Application number: 23197366.0
(22) Date of filing: 14.09.2023
(51) Int. Cl.: G11C 11/16, G06F 7/58, G06N 3/047

(54) **TUNABLE PROBABILISTIC MRAM ELEMENTS**

(71) Applicant: Imec VZW, 3001 Leuven (BE)
(72) Inventor: KUMAR, Ankit, 3001 Heverlee (BE); COUET, Sebastien, 1390 Grez-Doiceau (BE)
(74) Representative: Winger

(57) **Abstract**

A spintronic device (100; 200) for random bit generation and related method. The device comprises a magnetic tunnel junction (302) formed in a multilayer stack (301) of a magnetoresistance (112; 300), wherein a free layer (303) of the magnetic tunnel junction exhibits an electric-field depending perpendicular magnetic anisotropy. The device further comprises means for generating a magnetic bias field (306) along a predefined axis in the plane of the free layer, a junction biasing circuit (110) for eliminating an energy barrier associated with the magnetic anisotropy, a probability tuning circuit (130) for applying a controllable spin torque to the free layer, and a readout circuit (120; 220). The junction biasing circuit is configured to apply a controllable bias voltage (VB) across the magnetic tunnel junction, thus allowing thermal random switching of the free layer magnetization (FL-M). The spin torque exerted on the free layer changes the expected value of the free layer magnetization. The readout circuit senses and digitizes fluctuations of the magnetoresistance signal.

## Description

### Field of the invention

The present invention relates to the field of tunable spintronic devices for random bit generation and probabilistic compute networks using these devices in optimization and machine learning applications.

### Background of the invention

Random bit generation by thermally unstable magnetic memory elements has been suggested and demonstrated in the literature.

Document US10607674 B2 discloses a thermally unstable in-plane magnetized nanomagnet as the free layer of a magnetic tunnel junction, which is operated in the superparamagnetic regime to cause random fluctuations in the resistance of the magnetic tunnel junction. The magnetic tunnel junction is connected to an inverter which amplifies voltage fluctuations across the magnetic tunnel junction. An average of the output signal produced by the inverter can be controlled through the gate voltage of a transistor in series connection with the magnetic tunnel junction. A disadvantage of the proposed device is that thermally unstable nanomagnet require very low energy barriers that are difficult to reproduce in a reliable manner. Furthermore, a larger tunnel magnetoresistance (TMR) coefficient is required to achieve voltage fluctuations that are of the same order of magnitude as the supply voltage level.

In Sengupta, A., Panda, P., Wijesinghe, P. et al., "Magnetic Tunnel Junction Mimics Stochastic Cortical Spiking Neurons", Sci. Rep. 6, 30039 (2016), the authors present a neuromorphic system that uses stochastic magnetic tunnel junctions(MTJ) to mimic probabilistic cortical spiking neurons. The in-plane component of magnetization of the nanomagnet are considered equivalent to the membrane potential of a biological neuron and neural firing events are associated with the MTJ switching from the initial parallel state (P) to the antiparallel state (AP). The torque exerted by the effective magnetic field and the damping term of the magnetization dynamics are treated as leak terms, whereas the spin torque relates to the integration of input pulses during a write phase. Additionally, potential neuron switching during the write phase is verified in a subsequent read phase, which also serves the purpose of resetting the neuron back to the P state in case the MTJ switched to the AP state. The authors also studied a spiking neural network of stochastic MTJ neurons for solving a standard digit recognition problem. Current pulses of hundreds of microampere in amplitude are required as inputs to the MTJ neurons. The magnetic free layers of MJT neurons are nanomagnets with energy barrier height of 20 kT. A disadvantage of the proposed stochastic MJT neurons is that they require a two-phase operation, i.e. a write and a read phase with neuron reset, which slows done their operational speed and increases the energy consumption.

### Summary of the invention

It is an object of embodiments of the present invention to provide reliable and scalable spintronic random bit generators with adjustable bit expectancy.

The above objective is accomplished by a device and method according to the present invention.

In a first aspect, the present invention relates to a spintronic device for probabilistic or random bit generation. The random bit generating spintronic device comprises a magnetic tunnel junction that is formed in a multilayer stack of a magnetoresistance element, wherein a magnetic free layer of the magnetic tunnel junction exhibits an electric-field depending magnetic anisotropy in a direction perpendicular to the magnetic tunnel junction. The spintronic device further comprises an arrangement for generating a magnetic bias field along a predefined axis in the plane of the magnetic free layer, a junction biasing circuit for completely or partially eliminating an energy barrier associated with the magnetic anisotropy, a probability tuning circuit configured to apply a controllable spin torque to the free layer of the magnetic tunnel junction of the magnetoresistance, and a readout circuit. The junction biasing circuit is configured to apply a controllable bias voltage across the magnetic tunnel junction of the magnetoresistance, thus allowing thermal random switching of the free layer magnetization whilst precessing about the predefined axis of the magnetic bias field for a vanishing perpendicular magnetic anisotropy at zero energy barrier height. A random switching event corresponds to the flipping (direction reversal) of the component of the free layer magnetization vector that is parallel/antiparallel to the magnetization direction of the magnetic reference layer of the magnetic tunnel junction. The spin torque exerted on the magnetic free layer of the magnetic tunnel junction controls the statistical mean value of the free layer magnetization with respect to an ensemble of thermal random switching events. The readout circuit is adapted to detect fluctuations in the magnetoresistance at a rate compatible with the thermal random switching events and generate a binary output signal that is indicative of the currently detected resistance state, i.e. antiparallel or parallel magnetoresistance configuration. The readout circuit may sense and digitize a fluctuating voltage signal across the magnetoresistance or sense and digitize a fluctuating current through the magnetoresistance.

For partially eliminated energy barriers, the precession axis in respect of each equilibrium state of the magnetic free layer magnetization is tilted away from the easy axis associated with the free layer's residual perpendicular magnetic anisotropy and towards the predefined axis of the magnetic bias field, wherein the angle formed between the free layer magnetization vector and the magnetic bias field vector is smaller than the angle formed between the free layer magnetization vector and the easy axis. Here, partially eliminated energy barriers refers to energy barriers along the perpendicular direction of the free energy landscape related to the free layer magnetization, whose barrier height is smaller than 10 kT, preferably less than 5 kT.

After application of the junction bias voltage and the thereby caused energy barrier lowering or barrier elimination, the magnetic tunnel junction shows a strong stochastic behavior in which the magnetic moment orientation of the free layer is subjected to thermal noise. This creates random telegraph noise in the corresponding readout signal (e.g. via voltage or current sensing) in respect of the magnetoresistance, which is translated into a temporal stream of fluctuating random bits.

In embodiments of the invention, the magnetoresistance may be nanodevice so that the nanometer-sized magnetic free layer becomes a nanomagnet. The magnetic bias field may be an externally generated magnetic field or a magnetic field that is intrinsic to the free layer of the magnetic tunnel junction.

A magnetic hard mask may be provided in a layer that is positioned above or below the magnetic free layer, which is permanently magnetized in a direction parallel to the free magnetic layer. In this case, the predefined axis of the externally generated magnetic bias field corresponds to the magnetization direction of the hard mask. The magnetic hard mask may have an elongated cross-sectional shape (in a plane parallel to the magnetic free layer) that determines the magnetization direction of the hard mask as the consequence of magnetic shape anisotropy, or may show magnetocrystalline anisotropy in the plane parallel to the magnetic free layer.

An intrinsic magnet bias field may be provided within the magnetic free layer as a consequence of magnetic shape anisotropy, i.e. for magnetic free layers that have an elongated cross-sectional shape such as an elliptical shape.

In embodiments of the invention, the material layer stack may have a circular or non-circular shape, e.g. an elliptical shape, when viewed along the stacking direction. Furthermore, a thermal stability constant related to the magnetic tunnel junction, i.e. energy barrier height, preferably is at least 20 kT for unbiased magnetic junctions of the magnetoresistance, e.g. 0V junction bias voltage.

In embodiments of the invention, the magnetization direction of the reference layer of the respective magnetic tunnel junctions may be perpendicular or in-plane with respect to (the plane of) the magnetic free layer.

In embodiments of the invention, the magnetoresistance may comprise a plurality of parallelly connected magnetoresistive elements, wherein each magnetoresistive element comprises a magnetic tunnel junction that is formed in a respective multilayer stack.

Embodiments of the invention may comprise a voltage divider network formed by a reference resistance as first resistance and the magnetoresistance as second resistance of the voltage divider network. The readout circuit may comprise a comparator, invertor or a series of inverters, e.g. two or more inverters, connected to a sense node located between the first and second resistance of the voltage divider network. The reference resistance may be a resistor or a transistor operated as a current source.

A junction bias voltage across the magnetic tunnel junction(s) and/or a current-induced spin torque applied to the magnetic free layer(s) may be applied as dc signal or as a pulsed signal. A pulse duration preferably lasts for several times the precession period of the free layer magnetization, for example tens to hundreds of nanoseconds.

Spintronic random bit generators according to embodiments of the invention which use nanopillar-based magnetoresistances allow for energy-efficient and compact device implementations. They also offer the benefits of high throughput (e.g. at gigahertz sampling speed) per unit energy per unit area, efficient tunability of the expectancy related to the random bit, and massive parallelism.

It is an advantage of embodiments of the invention that the spin torque inducing charge current densities are significantly lower than the threshold current densities required for switching in conventional, thermally stable magnetic tunnel junctions. In embodiments of the invention, the spin torque inducing charge current density may be 100 kΩ/cm² to 500 kΩ/cm², or less than100 kΩ/cm².

It is an advantage of embodiments of the invention that spintronic random bit generators are configured to lower the energy barriers associated with the perpendicular magnetic anisotropy of the magnetic tunnel junctions through the voltage-controlled magnetic anisotropy (VCMA) effect. This avoids designing thermally unstable nanomagnets which, due to their very small diameters required for fast thermal switching, are difficult to scale and reproduce accurately. Moreover, application of a small in-plane magnetic bias field to the magnetic free layer under reduced or fully eliminated perpendicular energy barrier conditions allows for larger diameters of the magnetic free layer and multilayer stack at constant random switching rate.

In embodiments of the invention, a higher resistance area product, e.g. in the range of 100-500 Ω^{∗}µm², advantageously reduces the current tunneling through the magnetic tunnel junctions of the magnetoresistance when a junction bias voltage is applied, but still causes self-heating of the magnetic tunnel junction, e.g. a temperature increase of 10-50 K compared to ambient temperature. A higher junction temperature increases the fluctuation amplitude of the thermal random field and may further increases the switching rate.

It is an advantage of embodiments of the invention that spintronic random bit generators can be interconnected to form a network of random bit generators that does not require pairs of analog-to-digital and digital-to-analog conversion stages between connected random bit generators of the network. The random bit generators of the network of random bit generators can be updated in an asynchronous or synchronous manner, allowing the network to operate asynchronously or synchronously. Moreover, the random bit generators of the network enable efficient sampling of random bits, random numbers and/or random distributions derived from these random bits, in the framework of probabilistic computing and machines for probabilistic computation, for instance probabilistic implementations of machine learning models or combinatorial optimization problems. The network of random bit generators can be built on-chip and its sampling rate scales with the number of spintronic random bit generators, e.g. scales linearly with the number of spintronic random bit generators in asynchronously operating networks. Moreover, the junction biasing circuit of each spintronic random number generator may be optionally programmed to apply a predetermined amount of offset voltage across the magnetic tunnel junction to account for and compensate variability in the critical junction bias voltage across the spintronic devices of the network, prior to elimination of the energy barriers. This way, a common critical junction bias voltage can be applied uniformly to all the magnetic tunnel junctions of the network.

It is a further advantage of embodiments of the invention that spintronic random bit generators can be implemented in a compact manner and require less transistors than conventional digital implementation of random bit generators.

It is yet a further advantage of embodiments of the invention that the magnetoresistance state of the spintronic random bit generators can be switched at high temporal rates; fluctuations of the magnetoresistance state may occur within nanoseconds timescale.

The present invention also relates to method of generating probabilistic bits using a magnetoresistance. The method comprises the steps of:
(i) applying a bias voltage across a magnetic tunnel junction of the magnetoresistance, wherein a magnetic free layer of the magnetic tunnel junction exhibits an electric-field depending magnetic anisotropy in a direction perpendicular to the magnetic tunnel junction;
(ii) generating a magnetic bias field along a predefined axis in the plane of the magnetic free layer;
(iii) adjusting the bias voltage across the magnetic tunnel junction such that an energy barrier associated with the magnetic anisotropy is fully or partially eliminated, thus allowing thermal random switching of the free layer magnetization whilst precessing about the predefined axis of the magnetic bias field;
(iv) applying a controllable spin torque to the free layer of the magnetic tunnel junction of the magnetoresistance, thereby adjusting a mean value of the free layer magnetization with respect to an ensemble of thermal random switching events;
(v) detecting and digitizing a fluctuating voltage signal across or a fluctuating current signal through the magnetoresistance at a rate compatible with the thermal random switching events.

Steps (iii)-(v) are carried out simultaneously. A partially eliminated barrier has a remaining barrier height of less than 10 kT, preferably less than 5 kT.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, in which:
FIG. 1 and FIG. 2 are circuit diagrams of a spintronic random bit generator in accordance with embodiments of the invention.
FIG. 3 and FIG. 4 are cross-sectional views of magnetoresistive elements that can be used in spintronic random bit generators according to the invention.
FIG. 5 is circuit diagrams of a spintronic random bit generator according to a different embodiment of the invention, which uses multiple magnetic tunnel junctions.
FIG. 6 illustrates the working principles of the spintronic random bit generator during device operation.
FIG. 7 is a block diagram of a network of spintronic random bit generators in accordance with embodiments of the invention, which can be used in probabilistic computer hardware.
FIG. 8 is a flow diagram illustrating the steps of generating a random bit stream that uses a stochastic magnetic tunnel junction in accordance with embodiments of the invention.

The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, directional terminology such as top, bottom, front, back, leading, trailing, under, over and the like in the description and the claims is used for descriptive purposes with reference to the orientation of the drawings being described, and not necessarily for describing relative positions. Because components of embodiments of the present invention can be positioned in a number of different orientations, the directional terminology is used for purposes of illustration only, and is in no way intended to be limiting, unless otherwise indicated. It is, hence, to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art.

In the description provided herein, numerous specific details are set forth. However, it is understood that embodiments of the invention may be practiced without these specific details. In other instances, well-known methods, structures and techniques have not been shown in detail in order not to obscure an understanding of this description.

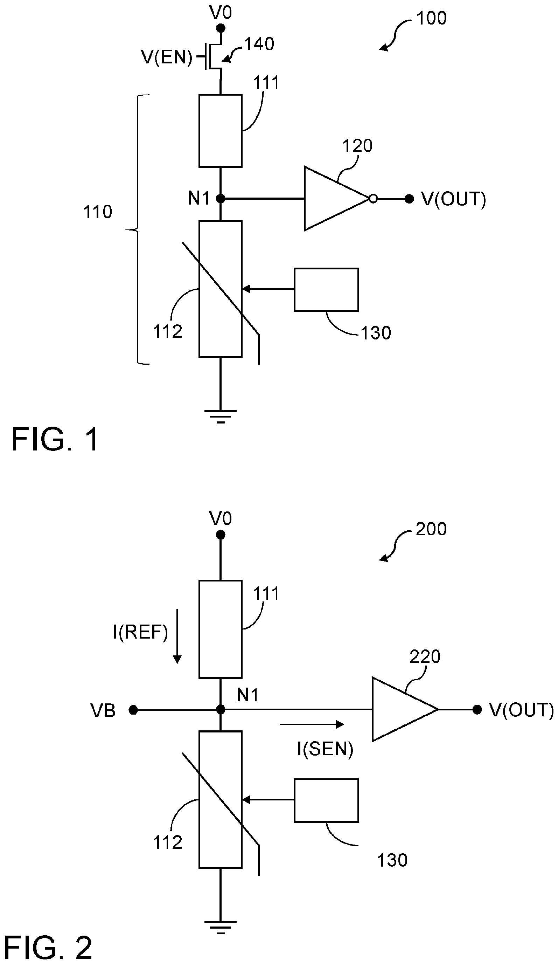

With reference to FIG. 1, a spintronic device for generating random bits with adjustable expectancy (also referred to as expected value, average or mean) according to an embodiment of the invention is described. The spintronic device 100 comprises a voltage divider circuit 110 in which a resistance network is formed of a first resistance 111 and second resistance 112 that are connected in series. In the resistance network, the first resistance 111 acts as a reference resistance, while the second resistance 112 is a switchable magnetoresistance. In embodiments of the invention, the first resistance may be provided as a resistor, a transistor (e.g. MOSFET) operated to mimic a resistor, a thermally stable magnetic tunnel junction having a fixed resistance (non-switching), or any other suitable resistive element, whereas the second resistance comprises at least one magnetoresistive element, e.g. is composed of a single magnetoresistive element or a plurality of parallel connected magnetoresistive elements. The at least one magnetoresistive element, e.g. each magnetoresistive element, comprises a magnetic tunnel junction (MJT) that is formed in a multilayer stack. A magnetic free layer of the MJT exhibits an electric field-dependent magnetic anisotropy in the direction perpendicular to the material interfaces of the multilayer stack. That is, the amount of interfacial perpendicular magnetic anisotropy in the magnetic free layer of the MJT can be controlled electrically through an electric field at the tunnel barrier-free layer interface (VCMA effect). In particular, it allows complete elimination of the energy barrier that separates the two opposite (bistable) magnetization states of the free layer in the permissible range of device operating temperatures, e.g. from -40°C to 120°C.

A readout circuit 120 is connected to a sense node N1 located between the two resistances 111, 112 of the voltage divider circuit 110 and is configured to convert voltage signal fluctuations at the sense node N1 into a corresponding digital output voltage signal V(OUT). Owing to the magnetoresistance effect, the second resistance has a higher resistance value R(AP) in the antiparallel state than in the parallel state, R(P). The first resistance is typically designed to have an associated resistance value, R(Ref), which is approximately equal to the mean resistance level of the second resistance, e.g. R(Ref) ≈ [R(AP)+R(P)]/2, such that the voltage signal at the sense node N1 fluctuates about a mean voltage level of approximately one half of the device supply voltage, e.g. <V(N1)> ≈ 0.5*V0. In embodiments of the invention, the readout circuit may comprise a voltage comparator to perform a threshold operation on the voltage signal at the sense node, V(N1), e.g. by comparing V(N1) to a reference voltage, e.g. V(REF) = 0.5*V0. Voltage signal fluctuation at the sense node N1, if too small, may be amplified by an optional amplification stage of the readout circuit. Alternatively, an inverter or a series of invertors (e.g. CMOS invertors) may be used to generate the random bit stream at the device output, e.g. a full-swing, digital output signal V(OUT), starting from thermally induced voltage fluctuations at the sense node N1. The readout circuit 120 is able to follow the fast thermal voltage fluctuations at the sense node N1, which are typically occurring in the sub-gigahertz to gigahertz range, e.g. greater than 0.1 GHz, provided it has a large enough frequency bandwidth (i.e., exceeding the thermal fluctuation rate at the sense node N1). In embodiments of the invention, the stochastic switching behavior of each magnetic tunnel junctions can be described by a process (e.g. noise process dominated by random telegraphic noise) whose spectral bandwidth is limited by the inverse of the RC time constant of the magnetic tunnel junction. It is thus advantageous to keep the RC time constant of the magnetic tunnel junctions small, e.g. by reducing the junction capacitance value, to increase the noise bandwidth and resulting readout signal fluctuation amplitude. The digital output signal V(OUT) generated by the readout circuit then is a binary-valued random variable (e.g., taking either one of the two distinct values '0' and '1'), thus realizing the generation of a random bit (also referred to as probabilistic bit or p-bit). Fluctuations in the value of the output signal V(OUT) over time correspond to successive realizations of the random bit (repeated drawings or samples of the random variable) and are due to thermal noise in conjunction with spin-torques causing abrupt changes in the tunnel magnetoresistance of the second resistance 112. A random bit stream can thus be generated at the device output in which individual p-bits are generated at random time points. In other words, the random bit stream of two random bit-generating spintronic devices are asynchronous. This has the advantage that a large number of random bit-generating spintronic devices can be operated in parallel in an asynchronous manner. However, it is also possible to provide a sampling unit at the device output such that the output voltage V(OUT) is sampled regularly, e.g. according to a clock signal. This allows a plurality of random bit-generating spintronic devices to be operated in a synchronous manner.

A switching element 140, e.g. a transistor, is optionally provided between the voltage supply 'V0' and the voltage divider circuit 110 for disconnecting the voltage divider circuit from the supply voltage if not in use. Energy savings can be made in this way and a lifetime of the magnetoresistive elements may be extended. The connection status of the voltage divider circuit 110, and possibly other components of the spintronic device 100 such as the readout circuit 120 and/or the control circuitry 130, is controlled through an enable signal V(EN) when applied to a control terminal of the switching element 140. The switching element 140 may also be used to generate supply voltage pulses, and hence junction bias voltage pulses across the at least one MTJ of the magnetoresistance, which have a predetermined duration, e.g. tens of nanoseconds.

In the present embodiment, the voltage divider circuit 110 applies the mean voltage level at the sense node, V(N1), across the at least one magnetic tunnel junction of the second resistance. It therefore fulfills the function of a junction biasing circuit of the device 100, which is configured to apply a controllable bias voltage across the at least one MJT of the magnetoresistance such that an energy barrier associated with the magnetic anisotropy in the magnetic free layer is fully eliminated. This implies that the voltage fluctuations at the sense node N1 should have a limited amplitude when the magnetoresistance is operated in the random telegraphic switching regime, e.g. have no significant impact on the bias voltage across the MJT in the sense that the energy characteristics of the magnetic free layer in the junction are not modified (i.e., no energy barrier re-formation). The junction bias across the at least one MTJ of the magnetoresistance is controlled via the supply voltage level 'V0'.

Furthermore, the spintronic device 100 comprises control circuitry 130 for tuning the expectancy (mean value) of the p-bits in the output stream. The control circuitry is configured to apply a current-induced spin torque to the MJT free layer magnetization. In preferred embodiments of the invention, the spin torque exerted on the MJT free layer is a spin-orbit torque caused by a charge current flown past the MJT free layer, e.g. adjacent to the MJT free layer interface. In this case, the probability tuning control circuit 130 comprises an adjustable current source and a charge current delivery means that converts at least a portion of the transported charge current into a spin current and/or interfacial spin, e.g. a current conductor or conductive track arranged underneath the vertical material layer stacks (MTJ stacks) of the magnetoresistance and interfacing the magnetic free layer of each MTJ stack. A portion of the control circuitry may thus be implemented by components of the magnetoresistance itself, e.g., the conductive track underneath the MTJ stacks. Changing the magnitude of the charge current supplied by the current source of the probability tuning control circuit enables control of the amount of spin torque that is exerted on the magnetic free layer of each magnetoresistive element. This perturbs the in-plane configuration of the effective magnetic field that governs the dynamics of the magnetic free layer in the absence of any perpendicular magnetic anisotropy, after elimination by the MTJ junction voltage bias, by addition of a small perpendicular component of the demagnetizing field for a magnetization vector that has been tilted out-of-plane. On average, the precession cone and relaxed state of the oscillating magnetic free layer magnetization are then shifted in the direction of the perturbation, albeit being subjected to a strong thermal noise field. Ultimately, this modifies the probabilities of generating p-bits with the values '0' and '1' respectively. Here, 'on average' means considering a large number of stochastic switching events. The magnetoresistive elements composing the magnetoresistance of the voltage divider circuit are generally implemented as three-terminal elements, e.g. the MTJ stacks each comprising a top contact and two bottom contacts realized as the two end terminals of the conductive SOT track that is shared by all the MJT stacks.

In alternative embodiments, the spin torque exerted on the MJT free layer is a spin-transfer torque caused by a (partially) spin-polarized charge current traversing the magnetic tunnel junction. In this case, the probability tuning control circuit 130 comprises an adjustable current source and a charge current delivery means that spin-polarizes at least a portion of the charge current injected into the magnetic free layer of the MTJ, e.g. the magnetic reference layer of the MTJ that acts as a spin polarizer. A portion of the control circuitry may thus be implemented by components of the magnetoresistance itself, e.g., the magnetic reference layers of the MTJ stacks. Changing the magnitude of the charge current supplied by the current source of the probability tuning control circuit enables control of the amount of spin torque that is transferred to the magnetic free layer of each magnetoresistive element. On average, this adds a small perpendicular component to the magnetic free layer magnetization, which adopts an in-plane configuration when the perpendicular magnetic anisotropy has been eliminated by the MTJ junction voltage bias. The magnetoresistive elements composing the magnetoresistance of the voltage divider circuit may then be implemented as two-terminal elements, e.g. the MTJ stacks each comprising a top and a bottom contact.

FIG. 2 shows another embodiment of the random bit-generating spintronic device. The spintronic device 200 differs from the previous device 100 in that the voltage at the node N1 is controlled directly by connecting the node N1 to a voltage source or voltage supply 'VB'. In consequence, the junction bias voltage across the at least one MTJ of the magnetoresistance 112 is set and controlled by the applied voltage level 'VB' and does not fluctuate over time if the device temperature is stable. Moreover, a reference current I(REF) is injected into the node N1, which may be generated by the first resistance 111 or a current source, e.g. a transistor operated as a current source (e.g. MOSFET transistor with or without source-degeneration). The reference current may be selected to be equal to the tunnel current through the magnetoresistance in its the highest resistance state. Upon a stochastic switching event of the magnetoresistance, a sense current I(SEN) flowing out of the node N1 is increased or decreased. This change in the sense current I(SEN) can be detected by a sense amplifier 220 and converted into a digital output signal V(OUT) that represents the random bit stream at the device output.

In the preceding embodiments the junction bias voltage across the at least one MTJ of the magnetoresistance can be adjusted as a function of the device operating temperature, which may include self-heating effects when the spintronic device is in use. As the height of the energy barrier that is to be eliminated by the junction bias voltage through the VCMA effect depends on the MTJ temperature, the applied junction bias voltage needs to be changed accordingly. A control loop associated with the junction biasing circuit may use temperature information, e.g. temperature sensor data, or derive temperature information from the device behavior to determine the correct value of the junction bias voltage to be applied across the at least one MTJ of the magnetoresistance. Additionally or alternatively, the random bit stream at the device output may be monitored to detect and compensate a temperature-induced deviation of the stochastic switching rate of the magnetoresistance.

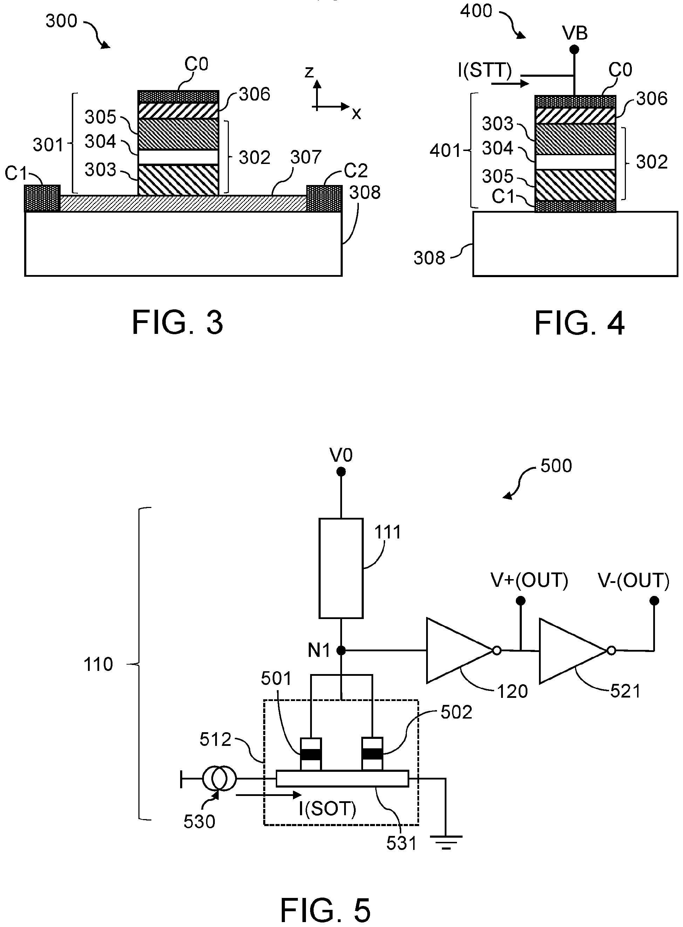

Referring now to FIG. 3, a cross-section through an exemplary magnetoresistive element 300 along the x-z plane is shown, which can be used as magnetoresistance in embodiments of the invention. The magnetoresistive element 300 comprises a multilayer stack 301 (MJT stack) that projects vertically from a conductive track 307 that is formed on a substrate or buffer layer 308. A magnetic tunnel junction 302 along the vertical multilayer stack 301 comprises an insulating tunnel barrier 304, sandwiched between a pair of magnetic electrodes 303 and 305. The first magnetic electrode 303 acts as the free layer of the MJT and is facing the conductive track 307, whereas the second magnetic electrode 305 acts as the perpendicularly (e.g. along the z-direction) or in-plane magnetized (e.g.. along the x-direction or y-direction) reference layer of the MJT and faces away from the conductive track 307.

The tunnel barrier 304 typically comprises a dielectric spacer, e.g. an oxide layer such as MgO, Al2O3, Gd2O3, BaO3Ti, or MgAl2O4 layer, and, compared to conventional MTJ designs for magnetic memory (e.g. MRAM) cells, may be formed thicker (e.g. 1.0...2.2 nm thick) to increase the resistance-area (RA) product of the insulating barrier film. A larger RA product, e.g. between 100 Ω^{∗}µm² and 500 Ω^{∗}µm², advantageously reduces the current tunneling through the junction 302 when a bias voltage is applied across it, thereby ensuring that the STT-effect caused by the tunneling current remains negligible at all time. In the vicinity with the tunnel barrier, the magnetic free layer displays interfacial perpendicular magnetic anisotropy energy that depends on the bias voltage that is applied across the junction 302. In consequence, the perpendicular magnetic anisotropy field can be adjusted through the bias voltage across the junction and even be fully eliminated. The linear magnetoelectric coefficient 'ξ' associated with the VCMA effect for the free layer perpendicular magnetization may be ξ = 30...100 fJ/V/m or larger.

The free layer 303 may comprise any of the following: a ferromagnetic material, a ferromagnetic alloy such as CoFeB, a ferrimagnetic alloy, a hybrid magnetic layer, a synthetic antiferromagnet (SAF), a synthetic antiferromagnet-hybrid free layer (SAF-HF) combination. The reference layer 305, as well as any hard layer if formed over the reference layer, may comprise any of the following: a ferromagnetic or ferrimagnetic alloy, an SAF, repeated Co/NM layers, repeated ferromagnet or ferrimagnetic alloy/NM layers (wherein NM stands for a non-magnetic material such as a refractory metal or alloys), an SAF-HF combination A capping layer 306 may be inserted into the MJT stack 301 for improved adhesion properties, e.g. between the reference layer 305 and a top contact C0, and comprises, e.g., a nonmagnetic transition metal or alloys, TiN, or a magnetic hard mask. If the magnetic hard mask/layer is provided within the capping layer or below the MTJ, an elongated shape (e.g. in the x-y plane) for the hard mask is preferred, e.g. to generate the magnetic bias field with respect to the free layer such that the magnetic bias field direction is determined by the elongate axis of the shape. The conductive track 307 comprises a material that creates an appreciable amount of spin-orbit torque at the interface with the free layer 303 when relaying a charge current between the side contacts C1 and C2. Exemplary choices for the SOT track 307 materials are: a ferromagnet/antiferromagnet bilayer, a ferromagnet/PtX bilayer, PtX; wherein X is one of the group of: non-magnetic material (NM), W, 5d- and 4d- NM materials and their alloys, NiOₓ, topological insulator, two dimensional transition metal dichalcogenides. In particular embodiments of the invention, which use an externally applied, in-plane magnetic bias field with respect to the magnetic free layer, the magnetic hard layer may be arranged underneath the SOT track instead of being provided in the capping layer.

A weak in-plane magnetic bias field (e.g. less than 10 mT) is applied to the free layer, e.g. along the x-direction or y-direction, resulting in a tilted configuration of the static free layer magnetization vector, wherein a tilt angle with respect to the vertical z-axis is small. The magnetic bias field determines the axis about which the free layer magnetization precesses, under the influence of thermal agitation and effective damping, as soon as the MTJ is biased at a critical level and perpendicular magnetic anisotropy vanishes. The effective Gilbert damping factor, as used in the Landau-Lifshitz-Gilbert (LLG) equations describing the free layer magnetization dynamics, may be α ≥ 0.01, e.g. α = 0.05, and includes both bulk and interface damping contributions and may be dependent on the junction bias voltage. In embodiments of the invention, the magnetic bias field may originate from a magnetic hard mask within the capping layer (external magnetic field), in-plane magnetic shape anisotropy internal to the free layer (inherent magnetic field along easy-axis), an uncompensated magnetic stray field from the reference layer. Contrary to MJT stacks with elliptically shaped cross-sections, a magnetic hard mask is preferred in MJT stacks with circularly shaped cross-sections (perpendicular to the z-axis) that do not exhibit any magnetic shape anisotropy.

The MJT stacks 301 may be provided as a pillars of various shapes and lateral dimensions, e.g. circularly or elliptically shaped pillars or nanopillars, wherein the cross-sectional area of nanopillars in a plane parallel to the stacked layers is generally below 100*100 nm², e.g. below 60*60 nm². For such small volumes of the magnetic free layer, the free layer magnetization is usually well described by a macrospin model. Even though the magnetic free layer is not necessarily constituting a single magnetic domain, the nucleation process during stochastic switching events generally affects the whole free layer volume. In other words, magnetization switching is predominately coherent, without significant displacement of domain walls if present.

The magnetoresistive element 300 is implemented as a three-terminal device, in which the junction bias voltage is applied to the top contact C0, a first side contact C1 is arranged at one end of the SOT track 307 for receiving an adjustable amount of SOT current, and a second side contact C2 is arranged at the opposite end of the SOT track 307 for electrical connection to a reference potential, e.g. ground. Therefore, biasing the junction 302 via the top contact is decoupled from the injection of the SOT current via one of the side contacts and junction bias voltage and SOT current can be controlled independently.

FIG. 4 shows a cross-section through another exemplary magnetoresistive element 400 along the x-z plane. Compared to the magnetoresistive element 300 of FIG. 3, the respective locations of the free layer 303 and the reference layer 305 in the stack 401 have been interchanged and the present magnetoresistive element 400 is configured as a two-terminal device that leverages the STT effect instead of the SOT effect for the purpose of tuning the p-bit expectancy via a current-induced spin torque. Given that there are only two control terminals C0 and C1, the junction bias voltage and the STT current through the junction 302 are interdependent. Indeed, the current I(STT) injected into the multilayer stack 401 is not negligible and causes an additional voltage drop across the junction 302, albeit this additional voltage drop is usually small compared to the already applied junction bias voltage (e.g. less than 10%). One approach consists therefore in ignoring the small interdependence and continue to adjust the STT current and junction bias voltage as if they were independent. Another approach consists in determining a set of orthogonal control variables, e.g. combinations of source current change and bias voltage change, which can be stored in a look-up table and lead to the desired values of the STT current and junction bias voltage.

For embodiments of the invention using the magnetoresistive element 400, the RA product associated with the tunnel oxide is typically designed to be smaller than 100 Ω^{∗}µm², e.g. by pillars of reduced cross-sectional area in the x-y plane and/or the use of thinner tunnel oxides, which facilitates delivery of a larger STT current and increases the efficiency of converting the STT current into transferable spin torque for tuning of the p-bit expectancy. The use of a smaller RA product is generally accompanied by a decrease in the linear magnetoelectric coefficient 'ξ' for the free layer, e.g. ξ = 50...100 fJ/V/m, or larger, for STT-assisted magnetoresistive elements using the VCMA effect.

The capping layer 306 of the vertical stack 401 may comprise a nonmagnetic or low coercive material, e.g., Fe_{y}Oₓ, HfOₓ, Cr_{y}Oₓ, or a transition metals and alloys. The free layer 303 in stack 401 may comprise the following materials: a ferromagnet, ferromagnetic alloys, ferrimagnet alloys, a transition metal-doped ferromagnet or ferrimagnet, an SAF, an SAF-HF combination. The reference layer 305 in the stack 401, as well as of any hard layer if provided in the stack, may comprise the following materials: SAF, SAF-HF combination, ferromagnetic or ferrimagnet alloys, repeated Co/NM layers, repeated ferromagnet or ferrimagnetic alloy/NM layers, wherein NM stands for a non-magnetic material such as a refractory metal or alloys. The insulating tunnel barrier layer 304 in stack 401 may comprise the following materials: MgO, Al₂O₃, Gd₂O₃, BaO₃Ti, MgAl₂O₄.

In both magnetoresistive elements 300 and 400, the polarity of the charge current that is converted into a spin current for exerting a spin torque on the free layer may be unipolar or bipolar. In the first case, the expectancy of the generated p-bits can be adjusted over the half-interval [0, 0.5] or [0,5, 1], while the second case allows adjustment of the expectancy over the full range [0, 1]. In neither of the magnetoresistive elements 300 and 400, the applied junction bias voltage should exceed a damaging threshold beyond which the tunnel barrier 304 of the MJT breaks down. For typical magnetoresistive elements in embodiments of the invention, the damage threshold is usually located above 2V for thermal stability constants in the range of 10-20 kT (at zero junction bias).

FIG. 5 is a variant of the spintronic random bit generator. The spintronic device 500 differs from the previous embodiments in that the second resistance 512, i.e. the magnetoresistance, comprises two identical but independent magnetoresistive elements 501 and 502, the magnetic tunnel junctions of which are connected in parallel without experiencing magnetic cross-talk. The multilayer stacks of magnetoresistive elements 501, 502 are formed on a common conductive track 531. Resistive losses between the spaced-apart magnetoresistive elements along the track, as well as the corresponding voltage drops, are negligeable as long as the number of magnetoresistive elements that are arranged on the same track is less than a maximum number of magnetoresistive elements. In practice, the number 'N' of magnetically decoupled, spaced-apart magnetoresistive elements along the track is typically in the range N = 2, ..., 16, e.g. N = 2...8, e.g. N = 2..4.

The conductive track 531 may comprise a heavy metal that exhibits spin-hall behavior under charge current injection. In this case, a controlled amount of charge current I(SOT) is generated by the current source 530, injected into the common track 531 and flown past the interfaces with the material stacks of magnetoresistive elements 501 and 502. The charge current induces a spin current in the direction perpendicular to both the charge current I(SOT) and the interfaces with the material stacks of magnetoresistive elements 501 and 502, e.g. along the vertical stacking direction of magnetoresistive elements 501 and 502, which leads to an accumulation of spin adjacent to the magnetic free layers of the magnetoresistive elements 501 and 502. The accumulated spin, in turn, exerts a spin torque on the magnetization vector of the two magnetic free layers. In alternative embodiments of the invention, the material interface between the conductive track and the magnetoresistive elements may be designed for other forms of spin-orbit coupling, e.g. via the Rashba or Dresselhaus mechanism.

The spintronic device of the present embodiment has the advantage that the combination of two stochastic MJTs accelerates the generation of probabilistic bits. Indeed, the two magnetoresistive elements are not coupled to each other and their magnetization states switch independently over time. Assuming that the switching events of the individual MJTs are accurately described by two uncorrelated Poisson processes with rates 'r1' and 'r2', the combination of the two Poisson processes is another Poisson process whose rate 'r' is the sum of the two rates: r = r1+r2. In other words, the voltage fluctuations originating from the two independent MTJs are superimposed at the sense node N1 and vary at a faster rate, e.g. twice the rate of a single MTJ if r1 and r2 are sufficiently close. However, the mean resistance values of the two MJTs are identical, because the injected charge current I(SOT), the resulting spin torque, and the applied junction bias voltage are substantially the same for the two magnetoresistive elements.

The combination of the two stochastic switching MJTs also reduces any residual probability bias, e.g. any residual perpendicular magnetic anisotropy field, which would favor one of the two outcomes over the other. This leads to improved p-bit statistics and random bit generators of higher quality. Although the combination of the two or more stochastic switching MJTs has been illustrated for the case of magnetoresistive elements of the SOT-type, embodiments of the invention can also combine two or more stochastic switching magnetoresistive elements of the STT-type. This can be achieved, for instance, by replacing the common SOT track by a common bottom contact C1 and providing a current divider circuit which splits a source current into a number N of approximately equal STT-currents, where N is equal to the number of parallelly connected magnetoresistive elements that compose the magnetoresistance. Alternatively, a number N of independent calibrated current sources can be used independently.

Spintronic random number generators in accordance with the invention may have two device outputs, e.g. V+(OUT) and V-(OUT), at which the random bit stream is generated together with its logical complement. As shown in the embodiment of FIG. 5, this can be achieved by providing a further inverter circuit 521 at the output of the readout circuit 120, which converts the digital signal V+(OUT) into its complement V-(OUT). Furthermore, the respective positions of the first and second resistive element in the voltage divider network may be interchanged in embodiments of the invention.

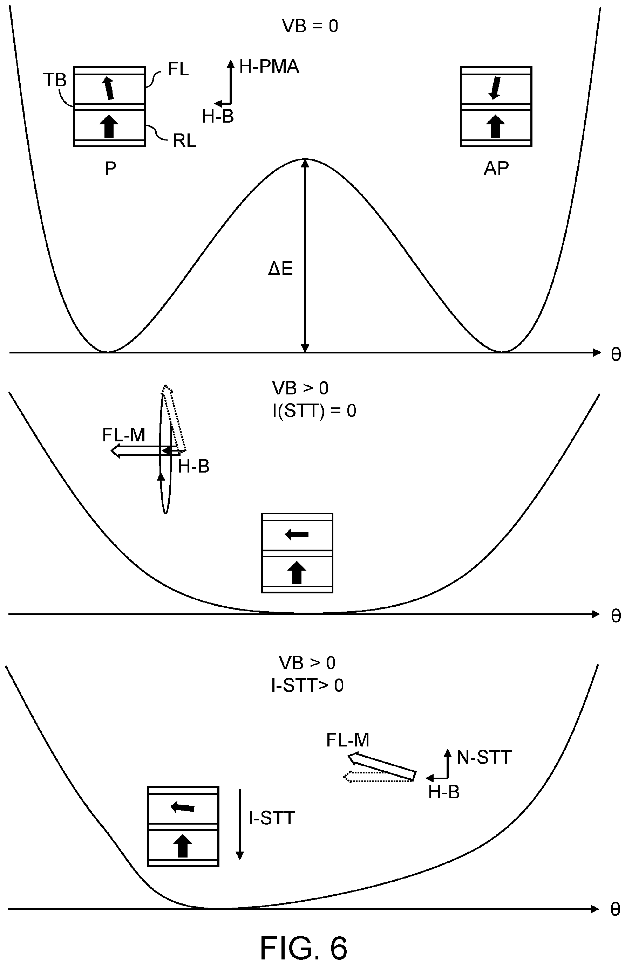

FIG. 6 explains how the magnetoresistive elements of the spintronic device are operated to achieve stochastic switching for random bit generation, as well as how the expectancy of the random bits is adjusted. If no junction bias voltage 'VB' is applied, the static free layer magnetization of the MJT in the magnetoresistive element can be in one of two bistable states that are separated by an energy barrier of height ΔE. The magnetization directions of the free layer (FL) and the reference layer (RL) in the magnetic tunnel junction with tunnel barrier (TB) are depicted for both states, which are respectively designated as the parallel state (P) and the antiparallel state (AP) with respect to the fixed perpendicular magnetization direction of the reference layer. Each of the two bistable states is characterized by a strong perpendicular component and a weak in-plane component that are due to the effective perpendicular magnetic anisotropy field (H-PMA) and in-plane magnetic bias field (H-B), respectively. The energy barrier is sufficiently high to suppress thermally-activated stochastic switching of the free layer magnetization between the two bistable states P↔AP, i.e. the MJT is in a thermally stable configuration. In embodiments of the invention, the free layer volume and energy density of the perpendicular magnetic anisotropy are designed such that an energy barrier height is 10 kT≤ ΔE(VB=0) ≤ 20 kT at room temperature T = 300 K, which is lower than the energy barrier heights (e.g. 40 kT≤ ΔE) in stable memory cells of conventional MRAM. Experiments have demonstrated that MJTs with lower energy barrier heights of only a few kT are difficult to scale; attempts have shown a large degree of device variability with respect to the achieved energy barrier heights. However, a good scaling behavior and reproducibility are vital for spintronic random bit generators that are intended for use in large-scale compute hardware, e.g. probabilistic computing architectures like Ising machines, Bayesian network machines, belief networks or Boltzmann machine. In embodiments of the invention, an energy barrier height variability of 4-5 kT across a large array of spintronic random bit generators is acceptable. On the other hand, too high energy barriers are disadvantaged by the fact that they require very large junction bias voltages to reduce the energy barrier by the VCMA effect to the regime of thermally-activated stochastic switching, with the ensuing consequences of higher energy consumption or electrical breakdown.

Owing to the magnetoresistive effect, which states that the resistance value of the MJT is a function of the polar angle (θ) between the magnetization vectors of the reference layer and the free layer, the MTJ resistance value in the P-state, R(P), is smaller than the MTJ resistance value in the AP-state, R(AP). The TMR coefficient of the MTJ is defined as TMR = 1+R(AP)/R(P) and, for embodiments of the invention, lies in the range between 100% and 250% at zero junction bias.

Next a critical junction bias voltage is applied across the MJT, which fully eliminates or at least significantly reduces the energy barrier (e.g. ΔE < 5 kT, e.g. ΔE ≈ 0) that previously separated the two bistable states. The critical junction bias voltage may be switched on suddenly and thereafter be applied as a dc signal, or may be applied in the form of a long voltage pulse, i.e. lasting much longer than the oscillation period of the ensuing free layer magnetization relaxation oscillations, e.g. tens or hundreds of nanoseconds. Through the VCMA effect, the easy axis in respect of the magnetic anisotropy energy density is converted into an easy plane and the energy profile, traced as a function of the free layer's magnetization polar angle θ, abruptly changes towards a bowl-like shape with minimum energy at polar angle θ = π/2. This defines at least one new equilibrium state for the free layer magnetization vector (FL-M) that lies in the plane of the free layer (azimuthal plane, θ = π/2). More precisely, two new energy minima emerge at opposite azimuthal angles (e.g. the antipodes ϕ = 0° and ϕ = 180° in the azimuthal plane θ = π/2) along the axis defined by the in-plane magnetic bias field if the in-plane magnetic bias field is an effective magnetic field that is due to magneto-crystalline anisotropy or shape anisotropy, e.g. for multilayer stacks in which the free magnetic layer has an elongated shape in a cross-section perpendicular to the vertical stacking direction. In the case of an externally applied in-plane magnetic bias field and an isotropic magnetostatic free energy landscape, a single energy minimum exists in the azimuthal plane that is aligned with the direction of magnetic bias field. If the energy barrier is only partially reduced in the direction of the free layer's easy axis, the externally applied in-plane magnetic bias field is counteracting the remaining effective perpendicular magnetic anisotropy field, which tilts the equilibrium magnetization vector of the free layer towards the azimuthal plane. Depending on the strength of the externally applied in-plane magnetic bias field relative to the residual effective perpendicular magnetic anisotropy field, the Stoner-Wohlfahrth model predicts one or two equilibrium states for the free layer magnetization. In all of the preceding cases, however, the initial magnetization of the free layer is close to being perpendicular to the free layer so that the free layer magnetization vector begins to relax towards one of its new equilibrium states. The dynamics of this relaxation process are accurately described by the LLG equations that are well-known in the field of micromagnetism and predict a damped precessional motion of the free layer magnetization about new equilibrium magnetization vector, which is substantially aligned with the in-plane magnetic bias field. Effective damping can be quite strong in embodiments and the precession may stop after two to twenty oscillation cycles, where an oscillation frequency is in the sub-gigahertz to gigahertz range, e.g. a few hundreds of MHz. What appears to be a regular relaxation process is in fact heavily influenced by thermal agitation. Thermal noise is well described by a Gaussian white noise process for the thermal random magnetic field that contributes to the effective magnetic field. The thermal random field has an associated noise power NP = α/(1+α²)^{∗}kT/(γ^{∗}M^{∗}V); where α is the effective Gilbert damping constant, γ the gyromagnetic ratio, M the saturation magnetization and V the free layer (macrospin) volume. As damping can be quite strong in embodiments of the invention and the free layer volume tends to be small in nanopillar MJT stacks, the impact of the thermal fluctuation field becomes very important. In consequence, an erratic behavior is superimposed on the relaxation oscillations of the free layer magnetization, which randomly flips the magnetization vector between opposite sides of the easy plane (i.e. stochastic switching of the magnetization), as well as between the antipodes within the easy plane in the case that the polar energy barrier has been reduced to zero. The polar component of the thermal random field and the azimuthal anisotropic bias direction, applied either by the hard mask or the elongate (e.g. elliptical) structure of the stack, govern the switching rate and hence the probabilistic bit's rate of sampling. Although strongly reduced with respect to its original value at zero junction bias, the TMR coefficient at applied junction bias voltage, TMR(VB=Vcrit), that is associated with stochastic fluctuations of the free layer magnetization may still be in the range of 20% to 50%, or higher. Since the thermal noise is isotropic and the dynamics of the free layer magnetization are not biased, the random bits caused by the random free layer magnetization flips have equal probability p = 0.5 of being '0' or '1'.

For completely eliminated energy barriers and junction voltages exceeding the critical junction bias voltage, the effective perpendicular magnetic anisotropy energy contribution to the total energy landscape crosses zero and reverses sign. This leads to strong energy gradients in the polar direction (e.g. out-of-plane direction) that greatly reduce the impact of the polar component of the thermal noise field and effectively confines the stochastic precessional motion of the free layer magnetic moment close to the azimuthal plane. Only during the thermally induced switching events of the free layer magnetization state between the azimuthal antipodes (azimuthal energy barrier crossing), where the free layer magnetization has sufficient energy to briefly explore larger polar angles, does the effective perpendicular magnetic field control the precession dynamics and causes a fast rotation about the perpendicular axis and into the other energy valley. An improved TMR coefficient in the stochastic switching regime (e.g. between 100 % and 250 %, or larger) can therefore be obtained in embodiments in which the magnetization of the reference layer has an in-plane configuration, e.g. lies in the plane of the reference layer. Moreover, the smaller the magnitude of the in-plane magnetic bias field that is applied to the free layer, the smaller the azimuthal energy barrier between the antipodes of the easy plane and the faster the random switching events between the two new equilibria. Note that the azimuthal energy barrier is different from the polar energy barrier, the latter being in the perpendicular direction and eliminated by way of the VCMA effect induced by the applied junction bias voltage.

To adjust the expectancy of the generated random bits, the free layer magnetization vector (FL-M) has to be biased so that its equilibrium position is tilted with respect to the easy plane of the free layer. Isotropic thermal noise provides zero average contribution to the angular deviation (θ) of the free layer magnetization, but the non-thermal bias does not average out under the thermal fluctuations. An out-of-plane bias can be achieved by a net spin torque 'N-STT' that acts on the free layer magnetization. In the situation that is depicted in the drawing, the spin torque 'N-STT' is generated by a spin-polarized current 'I-STT' through the free layer. In alternative embodiments, the spin torque can be generated by a charge current in the presence of spin-orbit coupling. The direction of current flow 'I-STT' through the free layer can be reversed so that a tilt of the free layer magnetization vector in the opposite direction with respect to the easy plane is achieved. The amplitude of the current controls the magnitude of the resulting spin torque and thus determines the final mean angular deviation (θ) of the free layer magnetization. The greater this angular deviation is, the longer it takes for the thermal fluctuations (random walk) to succeed in temporarily flipping the free layer magnetization into the opposite half-volume with respect to the easy plane. Therefore, the chances of observing the random bit in the '0' state are higher than observing the random bit in the '1' state, or vice versa. The expectancy of the binary random variable can thus be tuned through the current direction and magnitude. The functional relationship between the expectancy and the control current 'I' (e.g. I-STT or I-SOT) can be described by a sigmoid function 'σ', e.g. p = σ(I/I0), where I0 is some normalization constant.

A random bit generating spintronic device in accordance with embodiments of the invention can be used as a standalone random bit generator or a plurality of random bit generating spintronic devices can be used in combination, e.g. to obtain new random variables that are functions of a plurality of random bits or to construct random variables with multi-bit resolution. In particular, it is desirable to assemble a plurality of random bit generating spintronic devices into a larger asynchronous network or networks with reconfigurable connections between subsets of the plurality of random bit generating spintronic devices. The connectivity between random bit generating spintronic devices of the network depends on the application. For example, nearest neighbors in networks with a grid-like disposition of the random bit generating spintronic devices is frequently used in Ising machines - a particular type of probabilistic computing hardware. For machine learning and optimization applications, Boltzmann machines, belief networks or other type of layered probabilistic machine learning structures can be built from groups or blocks of random bit generating spintronic devices that are assigned to a network layer and random bit generating spintronic devices of different blocks are interconnected. This way, skip connections can also be implemented.

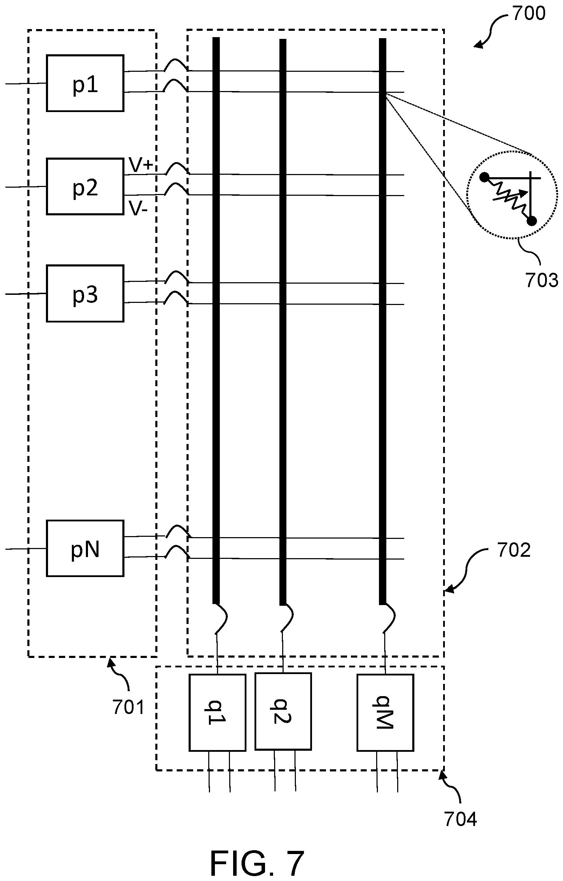

FIG. 7 shows fundamental building blocks 701, 702 that form (part of) a network of random bit generating spintronic devices in accordance with embodiments of the invention. For instance, Bayesian networks such or stochastic neural networks can be built from these building blocks, in which Monte Carlo or Gibbs samplers are required for updating intermediate results with respect to high-dimensional integration or probabilistic inference processes. A set of N random bit generators p1, p2, ..., pN are organized into a column that forms a first building block 701 of the network 700. This column of random bit generators may be identified with a layer of the network 700. A second building block 702 is provided by an interconnection module. Each random bit generator has two outputs, V+ and V-, for delivering two streams of random bits that are complements of each other (e.g., complementary bits represented by opposite voltage polarities). Alternatively or additionally, it is possible to use random bit generators with only a single output, e.g. V+ or V-, which deliver a single random bit stream. The output of each random bit generator p1 through pN is connected to a corresponding row of a crossbar array as the interconnection module, while columns of the crossbar array are connected to another block/layer 704 of M random bit generators q1, q2, ..., qM. If network layers are of the same size, then N = M, but this is not mandatory. A reconfigurable, e.g. programmable, conductance element 703 is provided at each point of intersection, where rows and columns of the interconnection module cross each other. The conductance elements perform a digital or analog weighting action on the random bit signal that is driving the row that is associated with the conductance elements. As a result, the random bit signals of the N random bit generators are first weighted by the conductance elements of a same column of the crossbar array and thereafter accumulated on the column, e.g. in the form of a weighted-sum current. In other words, the interconnection module 702 of size NxM is configured to carry out M multiply-and-accumulate operations on the N random bit input signals, each column of the module acting as a synaptic element. The reconfigurable conductance element 703 may be implemented as magnetic nanodevices, e.g., single bit or multi-bit MRAM cells, memristors, resistor-capacitor (RC) elements, or the like, which are optionally paired with capacitors to achieve time averaging of the incoming random bit streams. Hene, the crossbar array forms a tunable resistive bank. In some embodiments of the invention, the interconnection module may additionally perform a nonlinear transformation of the weighted-sum currents. The input of each random bit generator q1, q2, ..., qM of the further block 704 is then fed by the respective column current of the crossbar array. With reference to the magnetoresistive elements of FIGS. 3 and 4, the column currents play the role of the adjustable SOT or STT drive currents of the probability tuning circuits and thus achieve the input-dependent control of the mean value of the stochastic bits that are embodied by the random bit generators q1, q2, ..., qM. In particular, zero input SOT or STT currents (i.e. I/I0 = 0) do not bias the random bit generators and the resulting unbiased probabilistic bits have equal probability (p = 0.5) of taking either value '0' or '1'. In contrast thereto, positive or negative normalized input SOT or STT currents (i.e. I/I0 ≠ 0) effectively bias the random bit generators and the resulting biased probabilistic bits have unequal probability (p ≠ 0.5) of taking either value '0' or '1'. In the case of large positive or negative normalized input SOT or STT currents (i.e. I/I0 -> ± 1), the expectancy p of the probabilistic bit approaches and becomes quasi-pinned to either p = 1 or p = 0, meaning that the output stream essentially consists of only '1-bits' or only '0-bits'. The above-mentioned building blocks 701, 702 may be repeated and/or modified to construct more complex networks such as multilayered and/or recurrent networks. For example, each block of N random bit generators of a multilayered Bayesian network can be used to generate a Gaussian prior distributions with adjustable mean and/or variance, where larger numbers N of random bit generators lead to better approximations of Gaussian distributions, and the interconnection modules can be used to store and apply conditional probabilities. The weighted-sum outputs of the interconnection modules then represent the posterior probability distributions that can be forwarded to the next layer of the Bayesian network.

The above-described network 700 can also be used to solve optimization problems in the context of probabilistic compute hardware, an acclaimed alternative to conventional computing based on deterministic Turing machines. For instance, the nodes of an Ising machine are represented by the column of N random bit generators in block 701. Column currents produced by the interconnection module 702 are fed back to the random bit generators of block 701, i.e. in this case the two blocks 701 and 704 are identical and identified with each other. The optimization problem, e.g. an NP-complete combinatorial optimization problem, is programmed into the interconnection module 702 of the network 700 by first mapping the optimization problem to an energy function (e.g. Hamiltonian of the Ising model or equivalent cost function) and encoding the spin variables of the Ising model as p-bits and then setting the weights of the conductance elements according to the interaction strengths (coupling coefficients) of the energy function. Additional connections may be added that take into account constant inputs (e.g. linear terms in the energy or cost function). Asynchronous switching events in the magnetization states of the random bit generators correspond to the sampling or exploration of the systems' energy landscape in accordance with the Boltzmann probability distribution. At low enough system temperature, the network evolves towards its ground state where the system energy is minimal and the output behavior of the random bit generators becomes pinned to static '1-bits' or '0-bits'. However, the required time to finally observe the ground state may become excessively long if the system is caught in local energy minima. Therefore, it is advantageous to run a simulated annealing algorithm for solving the optimization problem on the network 700, which starts at an elevated system temperature with frequent transitions in the output streams of the random bit generators of the network and gradually decreases the temperature to lower the frequency of transitions in the output streams and ultimately block the network in its ground state, or at least in an acceptable suboptimal energy state . The annealing temperature can be set by re-establishing and increasing the (polar) energy barrier of the random bit generators over time, through a decrease in the applied junction bias voltage. Alternating anneal steps and system relaxation, the network slowly relaxes to its ground state (energy minimum) which represents the optimal solution. Solving optimization problems in the above-described way has the further advantage that random bit generator output states do not have to be continuously monitored by a control unit such as a microcontroller and, given that the output streams of the random bit generators are converted into drive currents, no extra components for the creation of analog SOT or STT currents (e.g. DACs) are required. Although simulated annealing has been given as an example algorithm that can be run on the network, other sampling-based algorithms such as Monte-Carlo or Quantum Monte-Carlo algorithms may be executed on networks of random bit generating spintronic devices.

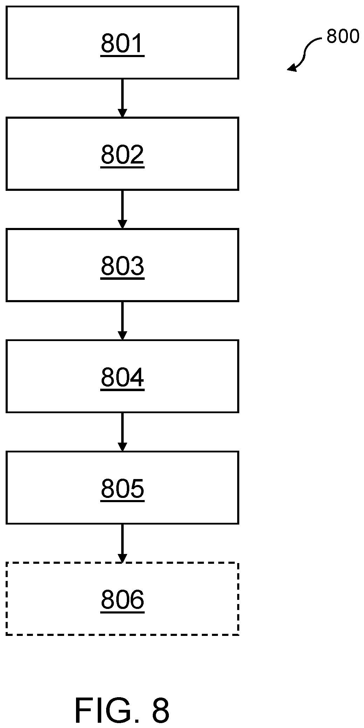

FIG. 8 illustrates the steps of a method 800 of generating probabilistic bits by means of a magnetoresistance, according to another aspect of the present invention. The magnetoresistance is comprising at least one vertical multilayer stack that includes a magnetic tunnel junction. Unbiased, i.e. at zero applied junction bias voltage, the magnetic tunnel junction is thermally stable during operating temperature conditions. Moreover, wherein a magnetic free layer of the at least one magnetic tunnel junction exhibits an electric-field depending perpendicular magnetic anisotropy, e.g. is susceptible to the VCMA effect.

In a first step 801, a bias voltage is applied across the at least one magnetic tunnel junction of the magnetoresistance, whereby the energy barrier associated with the perpendicular magnetic anisotropy is fully or partially eliminated. Partial elimination of the energy barrier for the perpendicular magnetic anisotropy is achieved if the applied junction bias voltage is less than a predetermined critical junction bias voltage, but large enough to render the magnetic tunnel junction thermally unstable. This is practically the case if the remaining energy barrier is less than 10 kT, e.g. less than or about 5kT. C Here, k is the Boltzmann constant and T the junction temperature, which may be higher than the ambient temperature due to self-heating effects. Control of the of applied junction bias voltage allows adjusting the energy barrier to a reduced height or even complete elimination thereof. The magnetization vector of the free layer is then agitated by thermal noise.

Next, a magnetic bias field is applied to the magnetic free layer of the at least one magnetic tunnel junction(MTJ) in step 802. This defines a preferential axis about which the free layer magnetization vector processes when subjected to the thermal noise. The thermal noise allows the free layer magnetization to randomly switch between the two energy minima of the energy landscape associated with the free magnetic layer. The applied magnetic bias field is oriented perpendicularly with respect to the multilayer stack with MTJ and preferably weak compared to the effective perpendicular magnetic field exerted on the free layer for the unbiased MTJ. For instance, the magnetic bias field is less than about 10 mT and may be created by a hard layer (hard mask) of the stack and/or caused by the in-plane shape anisotropy of the free layer, e.g. in a multilayer stack having an elongated cross-sectional shape in planes perpendicular to the stacking direction, e.g. elliptical cross-sectional shape.

Step 803 comprises applying a controllable spin torque to the free layer of the magnetic tunnel junction of the at least one magnetoresistance, thereby adjusting a mean value of the free layer magnetization with respect to an ensemble of thermal random switching events. The spin torque is induced by charge current, either through the STT effect or the SOT effect. In the former case, a controllable charge current is injected into the multilayer stack(s) and flown across each MTJ, whereas in the latter case a controllable charge current is flown past the free layers of one or more material stacks formed on a same current conducting track. The charge current may be provided by a gated or pulsed current source, wherein pulses last for several precession time periods of the free layer magnetization in the thermal switching regime, e.g. at last ten precession periods, e.g. between 1 ns and 1 µs. The polarity of the controllable current may be unipolar or bipolar, i.e. reversible.

The random switching events of free layer magnetization translate into changes in the TMR coefficient associated with each MTJ of the magnetoresistance. The fluctuating tunnel current through the MTJs of the magnetoresistance is then detected for the applied junction bias voltage in step 804 and transformed into a digital output voltage signal in step 805 at a rate compatible with the thermal random switching events. This may include comparing the tunnel current to a reference current, e.g. the mean current through the unbiased MTJs. Alternatively, a constant current source is used to generate a sense current that is passed through the magnetoresistance and a fluctuating voltage across the magnetoresistance is measured and digitized at a rate compatible with the thermal random switching events. The sense current is select small enough to not cause any measurable STT effect in the MTJs and ac voltage fluctuations across the magnetoresistance are typically small to the dc or quasi-dc applied junction bias voltage. The digitizing step may comprise comparing the fluctuating voltage signal across the magnetoresistance with a reference voltage signal, e.g. the mean voltage level of the unbiased MTJs, or supplying the fluctuating voltage signal across the magnetoresistance to the input of an inverter stage or a series of inverter stages. Optionally, the sensed voltage or current fluctuations are amplified prior to digitization in step 805. The thus obtained digital output signal contains a series of random transitions, i.e. bit flips, which are representative of the thermally induced switching events of the free layer magnetization.

Optionally, the binary output signal obtained in step 805 is converted into a digital current signal with multibit resolution in step 806. The conversion may be achieved by a programmable or configurable conductance element and the current signal may be added to multiple other current signals that are output by different conductance elements. Alternatively, conversion is into an analog current signal. The current signal obtained in step 806 may be used to generate the spin torque of step 803 with respect to the same magnetoresistance or another magnetoresistance.

The invention may be practiced in many ways and is not limited to the disclosed embodiments. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A spintronic device (100; 200; 500) for probabilistic bit generation, comprising:
a magnetoresistance (112) comprising a magnetic tunnel junction (302) formed in a multilayer stack (301) and a magnetic free layer (303) of the magnetic tunnel junction exhibiting an electric-field depending magnetic anisotropy in a direction perpendicular to the magnetic tunnel junction;
a means for generating a magnetic bias field along a predefined axis in the plane of the magnetic free layer;
a junction biasing circuit (110) for eliminating an energy barrier associated with the magnetic anisotropy, the junction biasing circuit being configured to apply a controllable bias voltage across the magnetic tunnel junction of the magnetoresistance, thus allowing thermal random switching of the free layer magnetization while precessing about the predefined axis of the magnetic bias field;
a probability tuning circuit (130) configured to apply a controllable spin torque to the free layer of the magnetic tunnel junction of the magnetoresistance, thereby adjusting a mean value of the free layer magnetization with respect to an ensemble of thermal random switching events;
a readout circuit (120; 220) adapted to sense and digitize voltage fluctuations across or current fluctuations through the magnetoresistance at a rate compatible with the thermal random switching events.

2. The spintronic device (500) of claim 1, the magnetoresistance (512) comprising a plurality of parallelly connected magnetic tunnel junctions formed in a corresponding plurality of spaced-apart multilayer stacks extending vertically from a conductive bottom track (531), the magnetic free layer of each magnetic tunnel junction exhibiting an electric-field depending magnetic anisotropy in the direction perpendicular to the magnetic tunnel junctions;
wherein the junction biasing circuit (110) is configured to apply the controllable bias voltage across the magnetic tunnel junctions of the magnetoresistance,
wherein the free layers of the of the magnetic tunnel junctions are contacting the conductive bottom track, and
wherein the probability tuning circuit (530) is configured to cause a current flow through the bottom track, the current to be flown being adjustable to control an amount of spin orbit torque exerted onto the free layers of the magnetic tunnel junctions of the magnetoresistance.

3. The spintronic device of claim 1 or 2, wherein a tunnel barrier (304) of the magnetic tunnel junctions of the magnetoresistance comprises single dielectric layer with resistance-area product RA ≤ 500 Ωµm².

4. The spintronic device of any one of the preceding claims, wherein the means for generating the magnetic bias field comprises a magnetic hard layer (306) for generating the magnetic bias field at the magnetic free layer of each magnetic tunnel junction, the magnetic hard layer being formed above or below the magnetic free layer and being magnetized in a direction that is parallel to the plane of the magnetic free layer,
or wherein means for generating the magnetic bias field comprises an elongated shape configuration of the magnetic free layer (303), thus creating an inherent magnetic shape anisotropy along the predefined axis in the magnetic free layer.

5. The spintronic device of claim 1, wherein the probability tuning circuit is configured to cause a spin-polarized current flow through the magnetic tunnel junction of the magnetoresistance, the spin-polarized current to be flown being adjustable to control an amount of spin transfer torque exerted onto the free layer of the magnetic tunnel junctions of the magnetoresistance.

6. The spintronic device of claim 5, wherein the probability tuning circuit comprises a tunable current source connected to one side of the magnetic tunnel junction.

7. The spintronic device of claim 6, wherein a tunnel barrier (304) of the magnetic tunnel junctions of the magnetoresistance comprises single dielectric layer with resistance-area product RA ≤ 100 Ωµm².

8. The spintronic device of any one of the preceding claims, wherein an operational frequency bandwidth of the readout circuit is in the GHz range.

9. The spintronic device of any one of the preceding claims, wherein one or more multilayer stacks of the magnetoresistance are provided as nanopillars.

10. The spintronic device of any one of the preceding claims, wherein the energy barrier associated with the magnetic anisotropy is at least 20 k_{B}T for the bias-free junction.

11. The spintronic device of any one of the preceding claims, wherein the multilayer stack of at least one magnetic tunnel junction of the magnetoresistance further comprises a capping layer, a material of said capping layer comprising at least one of: Fe_{y}Oₓ, HfOₓ, Cr_{y}Oₓ, transition metal, transition metal alloy.

12. A probabilistically sampled compute device comprising a network (700) of spintronic devices according to any one of the preceding claims, the spintronic devices in the network being coupled through synaptic elements, wherein each synaptic element is configured to generate weighted sums of the output signal from the readout circuits of a subset of the spintronic devices in the network, derive spin torque control signals from the weighted sums and apply the spin torque control signals to the probability tuning circuit of at least one spintronic device of the network.

13. The compute device of claim 12, wherein the synaptic elements are provided as tunable resistance banks (702), the resistance banks being arranged between blocks of spintronic devices to form a multilayer network.

14. A method (800) of generating probabilistic bits using a magnetoresistance, the method comprising:
(i) applying (801) a bias voltage across a magnetic tunnel junction of the magnetoresistance, wherein a magnetic free layer of the magnetic tunnel junction exhibits an electric-field depending magnetic anisotropy in a direction perpendicular to the magnetic tunnel junction;
(ii) generating (802) a magnetic bias field along a predefined axis in the plane of the magnetic free layer;
(iii) adjusting (801) the bias voltage across the magnetic tunnel junction such that an energy barrier associated with the magnetic anisotropy is eliminated, thus allowing thermal random switching of the free layer magnetization whilst precessing about the predefined axis of the magnetic bias field;
(iv) applying (803) a controllable spin torque to the free layer of the magnetic tunnel junction of the magnetoresistance, thereby adjusting a mean value of the free layer magnetization with respect to an ensemble of thermal random switching events;
(v) sensing (804) and digitizing (805) a fluctuating voltage signal across or a fluctuating current signal through the magnetoresistance at a rate compatible with the thermal random switching events.
